(19) Europäisches Patentamt
European Patent Office
Office européen des brevets

(11) **EP 1 867 065 B1**

(12) **EUROPÄISCHE PATENTSCHRIFT**

(45) Veröffentlichungstag und Bekanntmachung des Hinweises auf die Patenterteilung:
**10.08.2016 Patentblatt 2016/32**

(21) Anmeldenummer: **06722552.4**

(22) Anmeldetag: **06.03.2006**

(51) Int Cl.:
*H04B 3/30* *(2006.01)*

(86) Internationale Anmeldenummer:
**PCT/DE2006/000384**

(87) Internationale Veröffentlichungsnummer:
**WO 2006/105747 (12.10.2006 Gazette 2006/41)**

(54) **ELEKTRISCHES MEHRLEITERSYSTEM ZUR GEGENTAKT-SIGNALÜBERTRAGUNG MIT DÄMPFUNGS- ODER FILTERGLIED UND DATENÜBERTRAGUNGSBUS**

ELECTRICAL MULTIPLE-WIRE SYSTEM FOR PUSH-PULL SIGNAL TRANSMISSION WITH AN ATTENUATING OR FILTERING ELEMENT AND DATA TRANSMISSION BUS

SYSTEME ÉLECTRIQUE À PLUSIEURS CONDUCTEURS POUR LA TRANSMISSION SYMÉTRIQUE DE SIGNAUX, DOTÉ D'UN ÉLEMENT AMORTISSANT OU FILTRANT, ET BUS DE TRANSMISSION DE DONNÉES

(84) Benannte Vertragsstaaten:
**DE FR**

(30) Priorität: **07.04.2005 DE 102005016216**

(43) Veröffentlichungstag der Anmeldung:
**19.12.2007 Patentblatt 2007/51**

(73) Patentinhaber: **Conti Temic Microelectronic GmbH**
**90411 Nürnberg (DE)**

(72) Erfinder:
• **SCHUBERT, Göran**
**D-91126 Schwabach (DE)**

• **FISCHER, Thomas**
**91052 Erlangen (DE)**

(74) Vertreter: **Bonn, Roman Klemens et al**
**Continental Automotive GmbH**
**Patente und Lizenzen**
**Postfach 22 16 39**
**80506 München (DE)**

(56) Entgegenhaltungen:
**EP-A- 1 345 323     US-A1- 2004 135 646**

# EP 1 867 065 B1

**Beschreibung**

Die Erfindung betrifft ein elektrisches Mehrleitersystem zur Signalübertragung im Gegentaktmode mit mindestens zwei Signalleitungen und einer gemeinsamen Bezugsleitung, wobei jede Signalleitung ein Dämpfungs- oder Filterglied mit einem Verbindungszweig umfasst, der zwischen einem Abzweigknoten in der jeweiligen Signalleitung und der Bezugsleitung verläuft, und die Dämpfungs- oder Filterglieder der jeweiligen Signalleitungen nominell gleich dimensioniert sind. Außerdem betrifft die Erfindung einen Datenübertragungsbus.

Derartige Mehrleitersysteme kommen beispielsweise in einem Datenübertragungsbus zum Einsatz. Typische Anwendungsfelder liegen in der Datentechnik, in der Installationstechnik oder auch in der Kfz-Branche. Über das Mehrleitersystem werden Signale von einem Sender zu einem Empfänger übertragen. Die Signale umfassen üblicherweise einen Gleichtaktmode (= Common Mode) und einen Gegentaktmode (= Differential Mode), wobei die Information insbesondere mittels des Gegentaktmodes transportiert

EP 01345323 A1 beschreibt eine Vorrichtung, die unsymmetrische in symmetrische Signale und umgekehrt wandelt. Idealerweise sollen bei dieser Wandlung 100% des unsymmetrischen in das symmetrische Signal und umgekehrt gewandelt werden. Durch parasitäre Eigenschaften des Wandlers werden neben den differentiellen gegentaktartigen auch gleichtaktartige Anteile erzeugt. Diese entstehen auch durch Mismatching am Eingang/Ausgang des Wandlers. Es handelt sich demnach um eine unerwünschte Differential in Common Mode Transformation, die unterdrückt werden soll.

Die aus- und/oder eingangsseitig in jeder Signalleitung angeordneten Dämpfungs- oder Filterglieder dienen dem Schutz des angeschlossenen Senders bzw. Empfängers vor Störungen, die beispielsweise auf den Übertragungswegstrecken in das Mehrleitersystem eingekoppelt werden können. Die Dämpfungs- oder Filterwirkung sollte in jeder Signalleitung gleich sein, um die im Gegentaktmode transportierte Signalinformation nicht zu verfälschen. Die Dämpfungs- oder Filterglieder sind deshalb baugleich ausgeführt. Dennoch kommt es zu unerwünschten Überkopplungen vom Gleich- in den Gegentaktmode, deren Ausmaß oder besser gesagt deren Vermeidung durch die Gleichtaktunterdrückung (= Gleichtaktdämpfung) angegeben wird.

Die Aufgabe der Erfindung besteht darin, ein Mehrleitersystem der eingangs bezeichneten Art anzugeben, das gegenüber den bekannten Mehrleitersystemen eine verbesserte Gleichtaktunterdrückung aufweist.

Zur Lösung dieser Aufgabe wird ein Mehrleitersystem entsprechend den Merkmalen des Patentanspruchs 1 angegeben. Es wurde erkannt, dass ein erheblicher Teil der unerwünschten Überkopplungen vom Gleich- in den Gegentaktmode auf die Toleranzen der zur Realisierung der Dämpfungs- oder Filterglieder verwendeten Bauelemente zurückzuführen ist. Die Dämpfungs- oder Filterglieder sind üblicherweise Frequenzfilter, die mit passiven Komponenten aufgebaut sind. Gängig ist beispielsweise ein RC-Glied als Tiefpass erster Ordnung. Aber auch Tiefpässe höherer Ordnung sind ebenso möglich wie Ausgestaltungen als Band- oder Hochpässe. Gleichfalls ist eine Kaskadierung mehrerer Frequenzfilter möglich. Es hat sich gezeigt, dass die zur Realisierung der Blindwiderstände verwendeten Kondensatoren und/oder Spulen erheblich größere Toleranzen aufweisen als die ohmschen Widerstände, sodass die toleranzbedingten Abweichungen in den Kapazitäts- bzw. Induktivitätswerten der Dämpfungs- oder Filterglieder maßgeblich die Überkopplungen vom Gleich- in den Gegentaktmode verursachen.

Erfindungsgemäß wird der für die Gleichtaktunterdrückung entscheidende Einfluss der Blindwiderstandstoleranzen ganz wesentlich vermindert, indem ein einziger Blindwiderstand, nämlich der im zweiten Teilzweig angeordnete zweite Blindwiderstand, gleichermaßen Bestandteil aller Dämpfungs- oder Filterglieder ist. Da er nur einmal vorgesehen ist, spielt die Toleranz des zweiten Blindwiderstands keine Rolle. Die erfindungsgemäße Maßnahme, den ursprünglich im Verbindungszweig jedes Dämpfungs- oder Filterglieds vorgesehenen Blindwiderstand durch eine Serienschaltung mit mindestens zwei Blindwiderständen zu ersetzen und einen davon als Grundblindwiderstand allen Dämpfungs- oder Filtergliedern zuzuordnen, führt zu einer deutlichen Verbesserung, d. h. zu einem Anstieg, der Gleichtaktunterdrückung.

Die Blindwiderstände können gemäß Anspruch 2 und 3 vorzugsweise entweder als Kapazitäten oder als Induktivitäten ausgeführt sein. Auch Mischformen aus Kombinationen beider Blindwiderstandstypen sind möglich. Die Wahl der Blindwiderstände richtet sich nach dem durch die jeweilige Anwendung geforderten Frequenzverhalten. Je nach Ausführung der Blindwiderstände verhalten sich die Dämpfungs- oder Filterglieder wie Tief-, Band- oder Hochpässe mit im Prinzip beliebiger Ordnung.

Bei der Kapazitätsdimensionierung gemäß Anspruch 4 ist die Gesamtkapazität und auch die Gesamttoleranz der Serienschaltung maßgeblich durch die kleinere Kapazität, also die zweite Kapazität, bestimmt. Deren Toleranz spielt aber wie vorstehend ausgeführt keine Rolle, da die zweite Kapazität allen Dämpfungs- oder Filtergliedern gleichermaßen zugeordnet ist.

Bei der Variante nach Anspruch 5 handelt es sich um ein besonders einfach aufzubauendes Dämpfungs- oder Filterglied in Form eines Tiefpasses.

Die Ausgestaltung nach Anspruch 6 mit den zu beiden Seiten des Abzweigknotens angeordneten Längswiderständen verbessert vor allem bei hohen Frequenzen die Stabilität. Dies gilt insbesondere, wenn die Dämpfungs- oder Filterglieder als Eingangsbeschaltung eines Differenzverstärkers vorgesehen sind.

Die gemäß Anspruch 7 vorgesehene serielle Beschaltung mit einem ersten dämpfenden ohmschen Widerstand verringert die Güte im Gegentaktmode, und auch rezessiv im Gleichtaktmode, sodass die Schwingungsneigung und damit die Ausbildung unerwünschter Strom- oder Spannungsspitzen reduziert wird.

Die gemäß Anspruch 8 vorgesehene parallele Beschaltung mit einem zweiten dämpfenden ohmschen Widerstand verringert die Güte im Gleichtaktmode und führt insbesondere im unteren Frequenzbereich zu einer Erhöhung der Gleichtaktdämpfung.

Eine weitere Aufgabe der Erfindung besteht darin, einen Datenübertragungsbus anzugeben, dessen Mehrleitersystem gegenüber den bekannten Mehrleitersystemen eine verbesserte Gleichtaktunterdrückung aufweist.

Diese Aufgabe wird erfindungsgemäß durch einen Datenübertragungsbus gemäß den Merkmalen des Anspruches 9 gelöst. Beim erfindungsgemäßen Datenübertragungsbus ergeben sich im Wesentlichen die gleichen Vorteile, die bereits im Zusammenhang mit dem erfindungsgemäßen Mehrleitersystem beschrieben worden sind.

Bei den Ausgestaltungen des Datenübertragungsbusses gemäß Anspruch 10 erfolgt die Datenübertragung im Gegentaktmode, sodass das erfindungsgemäße Mehrleitersystem mit der günstigen Gleichtaktunterdrückung mit besonderem Vorteil zum Einsatz kommt.

Weitere Merkmale, Vorteile und Einzelheiten der Erfindung ergeben sich aus der nachfolgenden Beschreibung von Ausführungsbeispielen anhand der Zeichnung. Es zeigt:

Fig. 1    ein Ausführungsbeispiel eines Mehrleitersystems mit Dämpfungs- oder Filtergliedern,

Fig. 2    ein zweites Ausführungsbeispiel eines Mehrleitersystems mit modifizierten Dämpfungs- oder Filtergliedern,

Fig. 3    ein drittes Ausführungsbeispiel eines Mehrleitersystems mit modifizierten Dämpfungs- oder Filtergliedern, und

Fig. 4    ein weiteres Ausführungsbeispiel eines modifizierten Dämpfungs- oder Filterglieds.

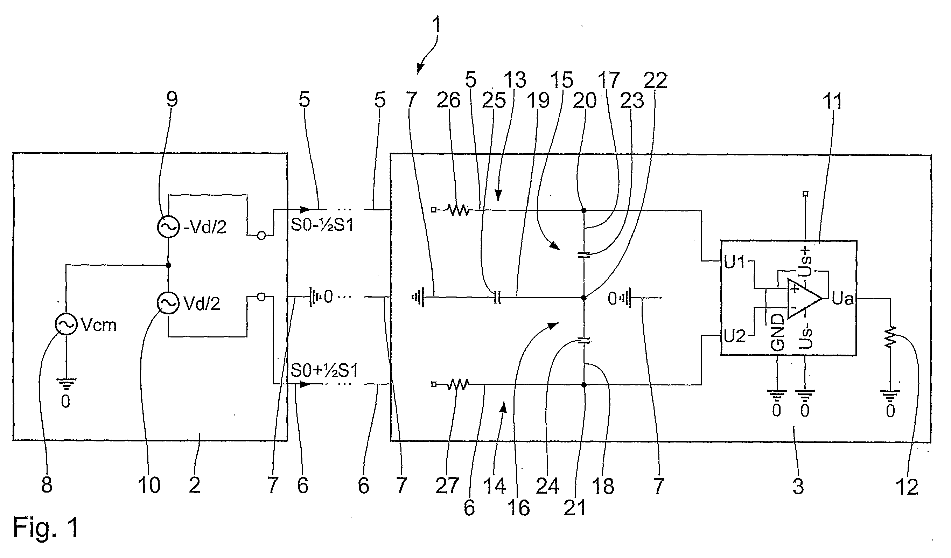

Einander entsprechende Teile sind in den Fig. 1 bis 4 mit denselben Bezugszeichen versehen.

In Fig. 1 ist ein Ausführungsbeispiel eines zur Signalübertragung vorgesehenen elektrischen Mehrleitersystems 1 gezeigt, an das mindestens eine Signal- oder Datenquelle 2 beispielsweise in Form eines Senders sowie eine Datensenke in Form eines Empfängers 3 angeschlossen sind. Das Mehrleitersystem 1 enthält drei Leitungen, nämlich zwei Signalleitungen 5 und 6 sowie eine gemeinsame Bezugsleitung, die im Ausführungsbeispiel als Masseleitung 7 ausgebildet ist. Grundsätzlich können auch mehr als zwei Signalleitungen und anstelle der Bezugsleitung an verschiedenen Stellen des Mehrleitersystems Anschlusskontakte an ein gemeinsames Bezugspotential, beispielsweise an das Massepotential, vorgesehen sein.

Die Signal- oder Datenquelle 2 ist nur schematisch dargestellt und zwar als stark vereinfachtes Ersatzschaltbild mit einer ein Gleichtaktsignal Vcm liefernden Gleichtaktspannungsquelle 8 und zwei Gegentaktspannungsquellen 9 und 10, die abgesehen von der Polarität jeweils ein identisches Gegentaktsignal Vd/2 liefern, und von denen eine an die erste Signalleitung 5 und die andere an die zweite Signalleitung 6 angeschlossen ist. Dagegen speist die Gleichtaktspannungsquelle 8 beide Signalleitungen 5 und 6. Die Signal- oder Datenquelle 2 ist allgemein zu verstehen. Sie ist nicht an einen bestimmten Ort innerhalb des Mehrleitersystems 1 gebunden. Vielmehr kann sie gedanklich an jede Stelle platziert werden, an der sich innerhalb des Mehrleitersystems 1 ein Signal ausbreitet, also insbesondere auch direkt an den Eingang des Empfängers 3.

Der Empfänger 3 enthält neben einem schematisch wiedergegebenen Differenzverstärker 11 und einer ausgangsseitig an den Differenzverstärker 11 angeschlossenen Last 12 auch zwei Dämpfungs- oder Filterglieder in Form von Tiefpässen 13 und 14, von denen jeweils einer eingangsseitig des Differenzverstärkers 11 in die Signalleitung 5 bzw. 6 geschaltet ist. Die im Wesentlichen als RC-Glieder aufgebauten Tiefpässe 13 und 14 sind Bestandteile des Mehrleitersystems 1. Grundsätzlich können weitere vergleichbare Tiefpässe auch an anderer Stelle im Mehrleitersystem 1, wie beispielsweise ausgangsseitig der Signal- oder Datenquelle 2, vorgesehen sein.

Die Tiefpässe 13 und 14 haben jeweils einen zwischen der jeweiligen Signalleitung 5 bzw. 6 und der Masseleitung 7 verlaufenden Verbindungszweig 15 bzw. 16, der sich aus einer Serienschaltung eines spezifischen Teilzweigs 17 bzw. 18 und eines gemeinsamen Teilzweigs 19 zusammensetzt. Die spezifischen Teilzweige 17 und 18 sind mittels Abzweigknoten 20 bzw. 21 an die Signalleitungen 5 bzw. 6 angeschlossen und münden in einen gemeinsamen Sternpunkt 22, von dem aus der gemeinsame Teilzweig 19 zur Masseleitung 7 verläuft. In den spezifischen Teilzweigen 17 und 18 sind spezifische Kapazitäten 23 bzw. 24 mit nominell gleichen Kapazitätswerten angeordnet. Der gemeinsame Teilzweig 19 umfasst eine gemeinsame Kapazität 25. Die Tiefpässe 13 und 14 enthalten weiterhin jeweils einen ohmschen Längswiderstand 26 bzw. 27, der in Signalflussrichtung betrachtet vor dem Abzweigknoten 20 bzw. 21 in die Signalleitung 5 bzw. 6 geschaltet ist. Auch die Längswiderstände 26 und 27 haben nominell den gleichen Widerstandswert, sodass die Tiefpässe 13 und 14 insgesamt gleich dimensioniert sind.

Im Folgenden wird die Funktionsweise des Mehrleitersystems 1 und insbesondere der Tiefpässe 13 und 14 näher beschrieben.

Die Informationsübertragung erfolgt bei dem Mehrleitersystem 1 im Gegentaktmode. Dies bedeutet, dass ein zu übertragendes Datensignal S1 auf die beiden Signalleitungen 5 und 6 gleich aufgeteilt wird, sodass in der einen Signalleitung 5 ein Teildatensignal -½S1 und in der anderen Signalleitung 6 ein Teildatensignal ½S1 geführt wird. Dem überlagert ist in Signalleitungen 5 und 6 ein identisches Gleichtaktsignal S0, das keinen Informationsgehalt aufweist.

Das Datensignal S1 (= Gegentaktsignal) und das Gleichtaktsignal S0 können jeweils sowohl als DC- oder als AC-Signal vorliegen, wobei beide Signale S0 und S1 auch durchaus im gleichen Frequenzbereich angesiedelt sein können.

Das Gleichtaktsignal SO kann dabei insbesondere durch die (DC-)Betriebsspannung bestimmt sein. Bei einer Anwendung im Kfz-Bereich ist dies das Potential der Kfz-Batterie, also 12 V oder 24 V. Möglich ist aber auch ein Wechselpotential mit einem Amplitudenwert im unteren V-Bereich, beispielsweise 1 V. Demgegenüber ist der Pegel des Datensignals S1 oft deutlich kleiner. Sein Amplitudenwert liegt insbesondere nur im mV-Bereich, beispielsweise bei 200 mV. Insgesamt ist dann an den Signalleitungen 5 und 6 also ein hohes Gleichtaktpotential und ein dem überlagertes niedriges Gegentaktpotential abgreifbar.

Um empfängerseitig den Informationsgehalt des Datensignals S1 zu extrahieren, werden die an den Signalleitungen 5 und 6 abgreifbaren Pegel dem Differenzverstärker 11 zugeführt. Aufgrund der Differenzbildung wird das informationslose Gleichtaktsignal S0 eliminiert. Dagegen addieren sich die Teildatensignale zu dem gesuchten Datensignal S1.

Die dem Differenzverstärker 11 vorgeschalteten Tiefpässe 13 und 14 führen eine Begrenzung des Frequenzgehalts entsprechend dem funktionalen Bereich durch. Dadurch werden die nachfolgenden Komponenten des Empfängers 3 vor in die Signalleitungen 5 und 6 eingekoppelten Störungen geschützt. Außerdem vermeidet die Frequenzbegrenzung unerwünschte Störeffekte im Differenzverstärker 11.

Das Prinzip der Gegentaktsignalübertragung beruht auf betragsmäßig exakt gleichen Teildatensignalen |½S1| in den beiden Signalleitungen 5 und 6. Abweichungen hiervon können zu einem Informations- und/oder Datenverlust führen. Deshalb sind die Signalleitungen 5 und 6 sowie sämtliche angeschlossenen Komponenten, wie auch die Tiefpässe 13 und 14, jeweils gleich ausgelegt.

Selbst bei der Verwendung von Bauelementen derselben Art, d. h. mit nominell gleicher Dimensionierung, kann es aufgrund der stets vorhandenen Bauelemente-Toleranzen zu einem leicht unterschiedlichen Übertragungsverhalten in den Signalleitungen 5 und 6 kommen. Dabei kann auch eine teilweise Überkopplung zwischen Gleich- und Gegentaktmode auftreten, wodurch sich das Datensignal S1 im Empfänger 3 möglicherweise nur noch unvollständig rückgewinnen lässt. Diese unerwünschte Gleichtakt-Gegentakt-Transformation ist vor allem bei einem hohen Gleichtaktpotential zu beachten.

Legt man Tiefpässe in Form konventioneller RC-Glieder zugrunde, die im Unterschied zu den Ausführungsformen gemäß Fig. 1 jeweils einen direkten und nur eine einzige Kapazität aufweisenden Verbindungszweig zur Masseleitung 7 haben, kommt es aufgrund der Bauelemente-Toleranzen zu erheblichen Überkopplungen. Diese lassen sich aus der Übertragungsfunktion eines idealen RC-Glieds gemäß:

$$H_1(\omega) = \frac{U_{Aus}}{U_{Ein}} = \frac{1}{\left(\dfrac{j\omega}{\omega_g} + 1\right)} \tag{1}$$

und der eines toleranzbehafteten RC-Glieds gemäß:

$$H_2(\omega, Tol_R, Tol_C) = \frac{U_{Aus}}{U_{Ein}} = \frac{1}{\dfrac{j\omega}{\omega_g}(1 + Tol_R + Tol_C + Tol_R Tol_C) + 1} \tag{2}$$

ermitteln, wobei mit

$$\omega_g = 2\pi f_g = \frac{1}{RC} \tag{3}$$

die Kreiseckfrequenz, mit fg die Eck- oder Grenzfrequenz, mit R der nominelle Widerstandswert der Längswiderstände 26 bzw. 27, mit C der nominelle Kapazitätswert der Querkapazität im Verbindungszweig zur Masseleitung 7 sowie mit $Tol_R$ und $Tol_C$ die Toleranz der Widerstände bzw. der Kapazitäten bezeichnet ist.

In der Kfz-Branche üblicherweise zur Realisierung einer Kapazität eingesetzte Keramikkondensatoren haben eine Toleranz $Tol_C$ von 10%. Dagegen sind Widerstände mit deutlich geringerer Toleranz zu vertretbaren Kosten verfügbar. Wenn Widerstände eines abgeglichenen Arrays eingesetzt werden, ist eine Toleranz $Tol_R$ von 0,1% zu erreichen. Folglich wird das toleranzbedingte Überkoppeln in den Gegentaktmode in erster Linie durch die Kondensatoren verursacht. Im ungünstigsten Fall liegt jedes Bauelement am Rand des Toleranzintervalls und die Einzeltoleranzen überlagern sich additiv, sodass von einer Gesamttoleranz von etwa 20% ausgegangen werden kann. Die beiden hier noch betrachteten konventionellen RC-Glieder haben insgesamt zwei Widerstände und zwei Kapazitäten, wobei die Toleranzen der Widerstände gegenüber denjenigen der Kapazitäten praktisch vernachlässigt werden können.

Eine Auswertung der Gleichungen (1) und (2) über der Frequenz f = ω/2π ergibt, dass die größte Abweichung und damit die größte Überkopplung in den Gegentaktmode im Bereich der Grenzfrequenz fg auftritt. Die maximal erreichbare Dämpfung oder Unterdrückung des aus dem Gleichtaktsignal S0 transformierten Gegentaktanteils ist also durch den Wert bei der Grenzfrequenz fg bestimmt. Diese auch als Gleichtaktunterdrückung bezeichnete Dämpfung kann gemäß:

$$\left| H_2\left(\omega = \omega_g, +Tol_C\right) - H_2\left(\omega = \omega_g, -Tol_C\right) \right| \tag{4}$$

ermittelt werden. Bei Annahme der vorstehend genannten Toleranzwerte für $Tol_C$ liegt sie beispielsweise bei nur 20 dB. Dies ist zu wenig für viele Anwendungen, so auch für die Kfz-Branche. Die Genauigkeitsanforderungen für die eingesetzten Regelkreise sind dort deutlich strenger und führen dementsprechend zu einer geforderten höheren Gleichtaktunterdrückung von insbesondere über 50 dB.

Legt man diese strengeren Genauigkeitsanforderungen zugrunde, ergibt sich mittels der Gleichungen (2) und (4) eine maximal zulässige Gesamttoleranz von 0,3%, die sich auf die Widerstandsgesamttoleranz von 0,1% und auf die Kondensatorgesamttoleranz von 0,2% aufteilt. Mit konventionellen RC-Gliedern und mit gängigen Kondensatoren ist diese Bedingung nicht zu erfüllen. Es würde wie bereits erwähnt eine Gesamttoleranz von etwa 20% resultieren.

Deshalb enthält das Mehrleitersystem 1 gemäß Fig. 1 anstelle konventioneller RC-Glieder die Tiefpässe 13 und 14. Insbesondere die Verbindungszweige 15 und 16 zur Masseleitung 7 sind anders ausgeführt als bei der Lösung mit konventionellen RC-Gliedern. Anstelle einer Kapazität ist jeweils eine Serienschaltung der spezifischen Kapazität 23 bzw. 24 und der gemeinsamen Kapazität 25 vorgesehen. Dadurch ergibt sich eine Sternschaltung der Kapazitäten 23, 24 und 25 bezüglich des Sternpunktes 22. Die Tiefpässe 13 und 14 sind auf diese Weise zu einem RC-Sternfilter zusammengeschaltet.

Schaltet man zwei Kapazitäten in Reihe, ist diejenige mit dem kleineren Kapazitätswert dominant. Folglich sinkt auch der Einfluss der Toleranz des Kondensators mit dem größeren Kapazitätswert gleichermaßen, wie sein Einfluss auf die Gesamtkapazität der Reihenschaltung sinkt. Bei der Zusammenschaltung der Kapazitäten 23 bis 25 gemäß Fig. 1 ergibt sich die Gesamtkapazität $C_G$ nominal zu:

$$C_G = \frac{\frac{1}{2}C_1 C_2}{\frac{1}{2}C_1 + C_2} \tag{5}$$

wobei mit $C_1$ der nominelle Kapazitätswert der gemeinsamen Kapazität 25, mit $C_2$ der nominelle Kapazitätswert der spezifischen Kapazität 23 bzw. 24 bezeichnet ist.

Gibt man auch die Gesamtkapazität $C_G$ in Form eines mit einer Toleranz δ behafteten Nominalwerts an, folgt:

$$C_G\left(1+\delta\right) = \frac{\frac{1}{2}C_1\left(C_2 + \Delta C_2\right)}{\frac{1}{2}C_1 + C_2 + \Delta C_2} \tag{6}$$

wobei mit Δ die Toleranz der spezifischen Kapazität 23 bzw. 24 bezeichnet ist. Mit Einführung eines Kapazitätsfaktors

$n = C_2/C_1$, der den Wertunterschied zwischen den Kapazitäten 23 und 24 einerseits und 25 andererseits angibt, errechnet sich die Toleranz $\delta$ zu:

$$\delta = \frac{\Delta}{1 + 2n(1 + \Delta)} \qquad (7)$$

Vorausgesetzt, dass die spezifischen Kapazitäten 23 und 24 sehr viel größer als die gemeinsame Kapazität 25 sind, also dass n>>1 gilt, kann aus Gleichung (7) für den Kapazitätsfaktor n die Beziehung:

$$n \approx \frac{\Delta}{2\delta} \qquad (8)$$

abgeleitet werden. Gemäß Gleichung (8) hängt der Kapazitätsfaktor n in guter Näherung nur von der Toleranz $\Delta$ des Kondensators mit dem größeren Kapazitätswert und von der Toleranz $\delta$ der Serienanordnung der beiden Kapazitäten 23 bzw. 24 und 25 ab.

Die Toleranz des zur Realisierung der niedrigerwertigen gemeinsamen Kapazität 25 eingesetzten Kondensators kann dagegen vernachlässigt werden. Dies lässt sich auch anhand von Plausibilitätsüberlegungen erklären. Die Kapazität 25 bewirkt in beiden Signalleitungen 5 und 6 gleichermaßen eine Verschiebung der Grenzfrequenz $f_g$ der Tiefpässe 13 bzw. 14, sodass diese Toleranz zur Gleichtakt-Gegentakt-Transformation nicht beiträgt.

Mit der vorstehend genannten und durch den Anwendungsfall bedingten Vorgabe von 0,2% für die Kondensatorgesamttoleranz als Toleranz $\delta$ der Serienanordnung sowie mit der üblichen 10%igen Toleranz für Keramikkondensatoren als Toleranz $\Delta$ des höherwertigen Kondensators errechnet sich aus Gleichung (8) ein Wertunterschied zwischen den spezifischen Kapazitäten 23 bzw. 24 einerseits und der gemeinsamen Kapazität 25 andererseits von mindestens zwei Größenordnungen, also $n \geq 25$.

Im Übrigen erfolgt die Dimensionierung der Bauelemente der Tiefpässe 13 und 14 anhand der Vorgaben für die Grenzfrequenz $f_g$. Die Tiefpässe 13 und 14 bedämpfen nicht nur den Gleichtaktanteil, sondern auch den Gegentaktanteil. Für beide Fällen resultiert allerdings eine andere Grenzfrequenz $f_{g\ Gleichtakt}$ bzw. $f_{g\ Gegentakt}$, die gemäß:

$$f_{g\ Gegentakt} = \frac{f_{g\ Gleichtakt}}{2n} \qquad (9)$$

miteinander verknüpft sind. Für n>>1 ergibt sich die Gleichtakt-Grenzfrequenz $f_{g\ Gleichtakt}$ zu:

$$f_{g\ Gleichtakt} = \frac{1}{2\pi RC_1} \qquad (10)$$

In der Praxis wird zuerst die Gegentakt-Grenzfrequenz $f_{g\ Gegentakt}$ entsprechend den funktionalen Anforderungen beispielsweise im Empfänger 3 bestimmt. Dann wird unter Einbeziehung der geforderten Gleichtaktunterdrückung entsprechend Gleichung (8) und (9) die Gleichtakt-Grenzfrequenz $f_{g\ Gleichtakt}$ festgelegt, um schließlich unter Berücksichtigung von Gleichung (10) die übrigen Dimensionierungen vorzunehmen.

Insgesamt wird mit den Tiefpässen 13 und 14 gemäß Fig.1 eine hohe Gleichtaktunterdrückung erreicht, selbst wenn die Kapazitäten 23 bis 25 mit den üblichen toleranzbehafteten Kondensatoren realisiert werden.

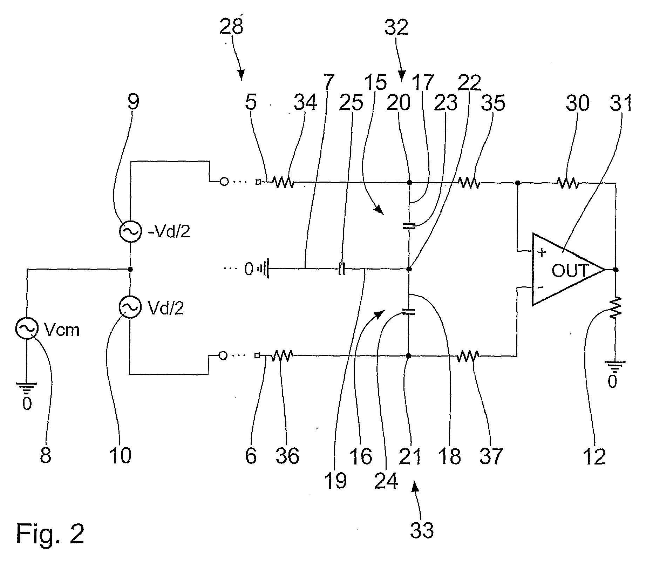

In Fig. 2 ist ein weiteres Ausführungsbeispiel eines leicht modifizierten, aber wiederum dreileitrigen Mehrleitersystems 28 gezeigt. Es bestehen nur wenige Unterschiede zum Ausführungsbeispiel von Fig. 1. So ist der in Fig. 1 nur schematisch gezeigte Differenzverstärker 11 beim Ausführungsbeispiel von Fig. 2 durch eine konkrete Realisierung als über einen Rückkopplungswiderstand 30 rückgekoppelter Operationsverstärker 31 ersetzt.

Auch die als Dämpfungs- oder Filterglieder eingangsseitig des Operationsverstärkers 31 in die Signalleitung 5 und 6 geschalteten Tiefpässe 32 bzw. 33 sind verglichen mit den Tiefpässen 13 bzw. 14 geringfügig geändert. Die ohmschen Längswiderstände 26 und 27 sind bei den Tiefpässen 32 bzw. 33 in zwei separate ohmsche Längswiderstände 34 und 35 bzw. 36 und 37 aufgeteilt, von denen jeweils einer in Signalflussrichtung vor und der andere in Signalflussrichtung nach dem Abzweigknoten 20 bzw. 21 angeordnet ist. Diese Aufteilung bewirkt bei hohen Frequenzen eine Begrenzung der Verstärkung und erhöht somit die Stabilität des Mehrleitersystems 28. Das Dämpfungsverhalten und insbesondere die vorteilhafte Gleichtaktunterdrückung erfahren durch die Widerstandsaufteilung keine nennenswerte Änderung.

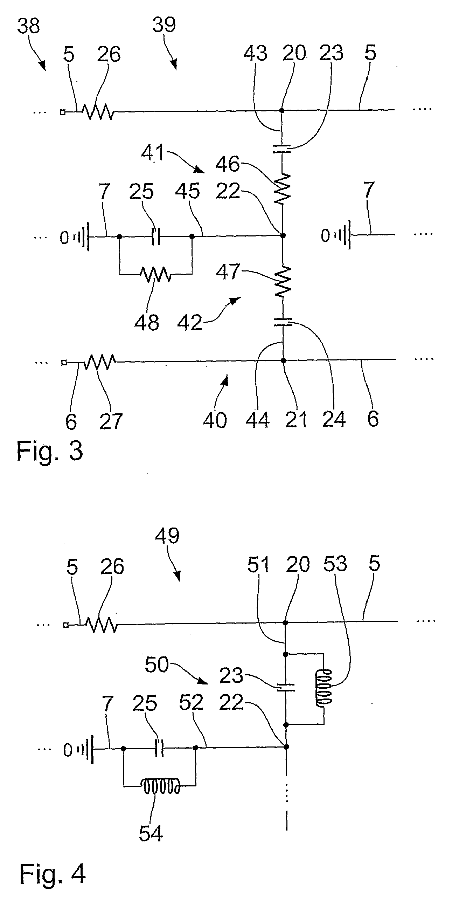

Ein weiteres Ausführungsbeispiel eines dreileitrigen Mehrleitersystems 38 ist in Fig. 3 gezeigt. Als Dämpfungs- oder Filterglieder sind Tiefpässe 39 und 40 vorgesehen, die gegenüber den Tiefpässen 13 bzw. 14 modifiziert sind.

Auch die Tiefpässe 39 und 40 haben aber jeweils einen zwischen der jeweiligen Signalleitung 5 bzw. 6 und der Masseleitung 7 verlaufenden Verbindungszweig 41 bzw. 42, der sich aus einer Serienschaltung eines spezifischen Teilzweigs 43 bzw. 44 und eines gemeinsamen Teilzweigs 45 zusammensetzt. In den spezifischen Teilzweigen 43 und 44 ist jeweils ein dämpfender ohmscher Widerstand 46 bzw. 47 in Serie zu der spezifischen Kapazität 23 bzw. 24 geschaltet. Die Widerstände 46 und 47 haben den gleichen nominellen Widerstandswert. Im gemeinsamen Teilzweig 45 ist ein dämpfender ohmscher Widerstand 48 parallel zur gemeinsamen Kapazität 25 geschaltet. Die zusätzlich vorgesehenen Widerstände 46 bis 48 bedämpfen die Güte sich ausbildender Resonanzen und begrenzen somit Spannungs- oder Stromüberhöhungen. Diese vorteilhafte Wirkung zeigt sich sowohl im Gleich- als auch im Gegentaktmode. Dies gilt insbesondere auch für eine nicht gezeigte alternative Ausführungsform, bei der anstelle der rein ohmschen Längswiderstände 26 und 27 EMV-Ferrite oder Induktivitäten vorgesehen sind.

In Fig. 4 ist ein weiteres Ausführungsbeispiel eines Dämpfungs- oder Filterglieds 49 gezeigt, das im Gegensatz zu den vorhergehenden Ausführungsbeispielen nicht als Tief-, sondern als Bandpass ausgeführt ist. Es umfasst wiederum einen zwischen der Signalleitung 5 und der Masseleitung 7 verlaufenden Verbindungszweig 50, der sich aus einer Serienschaltung eines spezifischen Teilzweigs 51 und eines gemeinsamen Teilzweigs 52 zusammensetzt. Im spezifischen Teilzweig 51 ist eine spezifische Induktivität 53 parallel zur spezifischen Kapazität 23 geschaltet, sodass sich insgesamt ein kombinierter spezifischer Blindwiderstand ergibt. Im gemeinsamen Teilzweig 52 ist eine gemeinsame Induktivität 54 parallel zur gemeinsamen Kapazität 25 geschaltet, sodass sich insgesamt ein kombinierter gemeinsamer Blindwiderstand ergibt.

Aufgrund der zusätzlich vorgesehenen Induktivitäten 53 und 54 besteht für tiefe Frequenzen eine niederohmige Verbindung zur Masseleitung 7. Folglich resultiert insgesamt ein Bandpassverhalten. Die vorstehend für die Kapazitäten angestellten Toleranz-Überlegungen sind analog auf die Induktivitäten 53 und 54 zu übertragen, wobei die spezifische Induktivität 53 einen kleineren nominellen Induktivitätswert hat als die gemeinsame Induktivität 54. Diese Aufteilung auf die beiden Teilzweige 51 und 52 führt auch hier zu einer Verbesserung der Gleichtaktunterdrückung, wenn, wie im Zusammenhang mit den Mehrleitersystemen 1, 28 und 38 beschrieben, jeweils ein Dämpfungs- oder Filterglied vom Typ des Dämpfungs- oder Filterglieds 49 in jede der Signalleitungen 5 und 6 eingefügt wird.

Weiterhin ist auch ein nicht gezeigtes Ausführungsbeispiel möglich, bei dem das Dämpfungs- oder Filterglied als reiner Hochpass ausgeführt ist, und in den Teilzweigen dementsprechend nur induktive Blindwiderstände vorgesehen sind.

Sämtliche der vorstehend beschriebenen Ausführungsbeispiele können bei verschiedenen Anwendungen zum Einsatz kommen. So ist beispielsweise ein Einsatz für eine Strommessung auf hohem Gleichtaktpotential möglich, wobei ein im Gegentaktmode über einem Mess-Shunt erfolgender Spannungsabfall mittels eines nachgeschalteten Differenzverstärkers bestimmt wird. Ein weiteres Anwendungsfeld betrifft die Datenbustechnik. Es gibt etliche Datenübertragungsbusse, die sich eines 3-Leitersystems bedienen, und bei denen die Informationsübertragung im Gegentaktmode erfolgt, sodass eines der Mehrleitersysteme 1, 28 und 38 unmittelbar und mit den genannten Vorteilen verwendet werden kann. Beispiele hierzu sind der CAN-Bus und der Flex Ray-Bus.

**Patentansprüche**

1. Elektrisches Mehrleitersystem zur Signalübertragung im Gegentaktmode mit mindestens zwei Signalleitungen (5, 6) und einer gemeinsamen Bezugsleitung (7), wobei

   a) jede Signalleitung (5, 6) ein Dämpfungs- oder Filterglied (13, 14; 32, 33; 39, 40; 49) mit einem Verbindungszweig (15, 16; 41, 42) umfasst, der zwischen einem Abzweigknoten (20,21) in der jeweiligen Signalleitung (5, 6) und der Bezugsleitung (7) verläuft,
   b) die Dämpfungs- oder Filterglieder (13,14; 32, 33; 39,40; 49) der jeweiligen Signalleitungen (5, 6) nominell gleich dimensioniert sind,
   c) der Verbindungszweig (15, 16; 41, 42) jedes Dämpfungs- oder Filterglieds (13, 14; 32, 33; 39, 40; 49) eine Serienschaltung eines ersten Teilzweigs (17, 18; 43, 44) mit einem ersten Blindwiderstand (23, 24; 53) und eines zweiten Teilzweigs (19; 45; 52) mit einer zweiten Blindwiderstand (25; 54) umfasst, und
   d) der zweite Teilzweig (19; 45) gemeinsamer Bestandteil aller Dämpfungs- oder Filterglieder (13, 14; 32, 33; 39,40; 49) ist, und
   e) der erste Blindwiderstand als erste Kapazität (23,24) und der zweite Blindwiderstand als zweite Kapazität (25) ausgeführt sind, und

dass die erste Kapazität (23,24) einen größeren Kapazitätswert aufweist als die zweite Kapazität (25).

2. Mehrleitersystem nach Anspruch 1, **dadurch gekennzeichnet, dass** dass die erste Kapazität (23, 24) einen um mindestens eine Größenordnung größeren Kapazitätswert aufweist als die zweite Kapazität (25).

3. Mehrleitersystem nach Anspruch 1 oder 2 , **dadurch gekennzeichnet, dass** das Dämpfungs- oder Filterglied (13, 14; 32, 33; 39, 40) ein RC-Glied mit einem in Signalflussrichtung vor dem Abzweigknoten (20, 21) in die Signalleitung (5, 6) geschalteten ohmschen Längswiderstand (26, 27; 34,36) umfasst.

4. Mehrleitersystem nach Anspruch 3 , **dadurch gekennzeichnet, dass** das Dämpfungs- oder Filterglied (32, 33) einen weiteren in Signalflussrichtung nach dem Abzweigknoten (20, 21) in die Signalleitung (5, 6) geschalteten ohmschen Längswiderstand (35, 37) umfasst.

5. Mehrleitersystem nach einem der Ansprüche 1 bis 4 , **dadurch gekennzeichnet, dass** der erste Teilzweig (43,44) einen ersten dämpfenden ohmschen Widerstand (46, 47) umfasst, der in Serie zur ersten Kapazität (23, 24) geschaltet ist.

6. Mehrleitersystem nach einem der Ansprüche 1 bis 4 , **dadurch gekennzeichnet, dass** der zweite Teilzweig (45) einen zweiten dämpfenden ohmschen Widerstand (48) umfasst, der parallel zur zweiten Kapazität (25) geschaltet ist.

7. Datenübertragungsbus **gekennzeichnet durch** ein Mehrleitersystem (1; 28; 38) nach einem der vorhergehenden Ansprüche.

8. Datenübertragungsbus nach Anspruch 7 , **dadurch gekennzeichnet, dass** eine Ausgestaltung als CAN-Bus oder als Flex Ray-Bus vorgesehen ist.

## Claims

1. Electrical multiconductor system for transmitting signals in the push-pull mode, having at least two signal lines (5, 6) and a common reference line (7), wherein

   a) each signal line (5, 6) comprises an attenuation or filter element (13, 14; 32, 33; 39, 40; 49) with a connecting branch (15, 16; 41, 42) which runs between a branch node (20, 21) in the respective signal line (5, 6) and the reference line (7),
   b) the attenuation or filter elements (13, 14; 32, 33; 39, 40; 49) of the respective signal lines (5, 6) nominally have the same dimensions,
   c) the connecting branch (15, 16; 41, 42) of each attenuation or filter element (13, 14; 32, 33; 39, 40; 49) comprises a series circuit comprising a first branch element (17, 18; 43, 44) with a first reactance (23, 24; 53) and a second branch element (19; 45; 52) with a second reactance (25; 54), and
   d) the second branch element (19; 45) is a common part of all attenuation or filter elements (13, 14; 32, 33; 39, 40; 49), and
   e) the first reactance is in the form of a first capacitance (23, 24) and the second reactance is in the form of a second capacitance (25), and

   the first capacitance (23, 24) has a greater capacitance value than the second capacitance (25).

2. Multiconductor system according to Claim 1, **characterized in that** the first capacitance (23, 24) has a capacitance value which is at least one order of magnitude greater than the second capacitance (25).

3. Multiconductor system according to Claim 1 or 2, **characterized in that** the attenuation or filter element (13, 14; 32, 33; 39, 40) comprises an RC element with a non-reactive series resistor (26, 27; 34, 36) connected into the signal line (5, 6) upstream of the branch node (20, 21) in the direction of signal flow.

4. Multiconductor system according to Claim 3, **characterized in that** the attenuation or filter element (32, 33) comprises a further non-reactive series resistor (35, 37) connected into the signal line (5, 6) downstream of the branch node (20, 21) in the direction of signal flow.

5. Multiconductor system according to one of Claims 1 to 4, **characterized in that** the first branch element (43, 44) comprises a first attenuating non-reactive resistor (46, 47) which is connected in series with the first capacitance (23, 24).

6. Multiconductor system according to one of Claims 1 to 4, **characterized in that** the second branch element (45) comprises a second attenuating non-reactive resistor (48) which is connected in parallel with the second capacitance (25).

7. Data transmission bus, **characterized by** a multiconductor system (1; 28; 38) according to one of the preceding claims.

8. Data transmission bus according to Claim 7, **characterized in that** a configuration in the form of a CAN bus or a FlexRay bus is provided.

**Revendications**

1. Système électrique à conducteurs multiples destiné à la transmission de signaux en mode symétrique, comportant au moins deux conducteurs de signaux (5, 6) et un conducteur de référence commun (7), dans lequel

   a) chaque conducteur de signal (5, 6) comprend un élément d'amortissement ou de filtrage (13, 14 ; 32, 33 ; 39, 40 ; 49) ayant une dérivation de connexion (15, 16 ; 41, 42) qui s'étend entre un noeud de dérivation (20, 21) présent dans le conducteur de signal respectif (5, 6) et le conducteur de référence (7),
   b) les éléments d'amortissement ou de filtrage (13, 14 ; 32, 33 ; 39, 40 ; 49) des conducteurs de signaux respectifs (5, 6) sont nominalement dimensionnés de manière identique,
   c) la dérivation de connexion (15, 16 ; 41, 42) de chaque élément d'amortissement ou de filtrage (13, 14 ; 32, 33 ; 39, 40 ; 49) comprend une connexion en série d'une première dérivation partielle (17, 18 ; 43, 44) ayant une première réactance (23, 24 ; 53) et d'une seconde dérivation partielle (19 ; 45 ; 52) ayant une seconde réactance (25 ; 54) ; et
   d) la seconde dérivation partielle (19 ; 45) constitue une partie commune de tous les éléments d'amortissement ou de filtrage (13, 14 ; 32, 33 ; 39, 40 ; 49), et
   e) la première réactance est réalisée sous la forme d'une première capacité (23, 24) et la seconde réactance est réalisée sous la forme d'une seconde capacité (25), et

   la première capacité (23, 24) présente une valeur de capacité supérieure à la seconde capacité (25).

2. Système à conducteurs multiples selon la revendication 1, **caractérisé en ce que** la première capacité (23, 24) présente une valeur de capacité supérieure d'au moins un ordre de grandeur à la seconde capacité (25).

3. Système à conducteurs multiples selon la revendication 1 ou 2, **caractérisé en ce que** l'élément d'amortissement ou de filtrage (13, 14 ; 32, 33 ; 39, 40) comprend un élément RC ayant une résistance série ohmique (26, 27 ; 34, 36) connectée dans le conducteur de signal (5, 6) dans la direction de passage des signaux en amont du noeud de dérivation (20, 21).

4. Système à conducteurs multiples selon la revendication 3, **caractérisé en ce que** l'élément d'amortissement ou de filtrage (32, 33) comprend une autre résistance série ohmique (35, 37) connectée dans le conducteur de signal (5, 6) dans la direction de passage des signaux en aval du noeud de dérivation (20, 21).

5. Système à conducteurs multiples selon l'une quelconque des revendications 1 à 4, **caractérisé en ce que** la première dérivation partielle (43, 44) comprend une première résistance ohmique d'amortissement (46, 47) qui est connectée en série à la première capacité (23, 24).

6. Système à conducteurs multiples selon l'une quelconque des revendications 1 à 4, **caractérisé en ce que** la seconde dérivation partielle (45) comprend une seconde résistance ohmique d'amortissement (48) qui est connectée en parallèle à la seconde capacité (25).

7. Bus de transmission de données **caractérisé par** un système à conducteurs multiples (1 ; 28 ; 38) selon l'une quelconque des revendications précédentes.

**8.** Bus de transmission de données selon la revendication 7, **caractérisé en ce qu'**il est réalisé sous la forme d'un bus CAN ou d'un bus Flex Ray-Bus.

Fig. 1

Fig. 2

Fig. 3

Fig. 4

**EP 1 867 065 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 01345323 A1